(19) Europäisches Patentamt
European Patent Office
Office européen des brevets

(11) Publication number: **0 021 718**
**B1**

(12) # EUROPEAN PATENT SPECIFICATION

(45) Date of publication of patent specification: **21.03.84**

(51) Int. Cl.³: **G 03 C 1/52,** G 03 F 7/08, B 41 N 1/14

(21) Application number: **80301957.9**

(22) Date of filing: **10.06.80**

(54) **Photosensitive condensation product, photosensitive compositions and lithographic printing plates containing said condensation product.**

(30) Priority: **16.06.79 JP 76216/79**

(43) Date of publication of application:
**07.01.81 Bulletin 81/1**

(45) Publication of the grant of the patent:
**21.03.84 Bulletin 84/12**

(84) Designated Contracting States:
**DE FR GB IT**

(56) References cited:
**EP - A - 0 021 716**
**DE - A - 1 803 712**
**DE - A - 2 545 327**
**DE - A - 2 742 631**
**US - A - 3 148 983**
**US - A - 3 188 210**

**The file contains technical information submitted after the application was filed and not included in this specification**

(73) Proprietor: **KONISHIROKU PHOTO INDUSTRY CO. LTD.**
**No. 26-2, Nishishinjuku 1-chome Shinjuku-ku**
**Tokyo 160 (JP)**

(72) Inventor: **Uehara, Masafumi**
**2-2-19 Sakura-cho Koganei-shi**
**Tokyo (JP)**
Inventor: **Shimada, Fumio**
**1410 Kumagawa Fussa-shi**
**Tokyo (JP)**
Inventor: **Iwaki, Akio**
**3-5-4 Mejirodai Hachioji-shi**
**Tokyo (JP)**
Inventor: **Matsuzaki, Masatoshi**
**5-2-2 Hinodai Hino-shi**
**Tokyo (JP)**
Inventor: **Ogawa, Yoko**
**3-17-6 Hon-cho Higashimurayama-shi**
**Tokyo (JP)**

(74) Representative: **Ellis-Jones, Patrick George Armine et al,**
**J.A. KEMP & CO. 14 South Square Gray's Inn**
**London WC1R 5EU (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).



Courier Press, Leamington Spa, England.

# Photosensitive condensation product, photosensitive compositions and lithographic printing plates containing said condensation product

The present invention relates to a photosensitive condensation product and to a composition suitable for a photosensitive lithographic printing plate of o-quinonediazide type.

It is known that when an o-quinonediazide compound is irradiated by actinic radiation, it decomposes to produce a carboxylic acid of a 5-membered ring compound which is soluble in alkali, such that a photosensitive positive lithographic printing plate can be made therefrom. Many of these o-quinonediazide compounds have been known so far and most of them are compounds of low molecular weight (see US—A—3188210, especially formulae 23, 24 and 27), therefore when these o-quinonediazide compounds are used independently as a photosensitive material, crystals separate out and the physical strength of the image is so weak that printing of many sheets of paper is difficult. Therefore, together with o-quinonediazide compounds, an alkali-soluble resin such as a phenolformaldehyde resin, cresolformaldehyde resin or styreneanhydrous maleic acid resin has been used as a carrier. In such case, the development is done utilizing a change of alkali solubility of the low-molecular o-quinonediazide compound by the exposure, but due to the fact that an alkali-soluble resin is a carrier, there have been some weak points — the range of developer concentration with which the proper development can be reproduced is narrow and non-exposed portion is lost remarkably or a part of the image is damaged and dissolved when developed.

Some examples of polymerizing the photosensitive substance itself to improve the abovementioned weak points are known.

U.S. Patent 3046120, Japanese Patent Publication Nos. 43—28403, 49—24361, 50—5083 and 50—5084 and Japanese Patent L—O—P Publication No. 50—36206 are given as examples. Among these patents, U. S. Patent 3046120, Japanese Patent Publication No. 50—5083 and Japanese Patent L—O—P Publication No. 50—36206 disclose that the o-quinonediazid group is substituted in a condensation type resin of a phenol or a substituted phenol and an aldehyde. In a photosensitive resin produced from a condensation type resin of a phenol or a substituted phenol and an aldehyde, the hydroxyl group content decreases because of esterification with o-quinonediazide-sulfonylchloride, and thereby the developing performance with an aqueous alkaline solution deteriorates considerably and the image strength is low; further the chemical resistance for various kinds of processing agents is poor, which might be caused by its low adhesion to the support especially to an aluminium plate. If the chemical resistance of the photosensitive layer is low, problems such as image reproducibility of low grade material and decreased durability for printing may arise.

On the other hand, as examples in which the o-naphthoquinonediazide group is substituted in a condensation type resin of a polyhydric phenol and an aldehyde or ketone group, Japanese Patent Publications Nos 43—28403, 49—24361 and 50—5084 may be given. In a photosensitive resin produced from a condensation type resin of a polyhydric phenol and an aldehyde or ketone group, the developing performance by an aqueous alkaline solution or adhesion to the support especially to an aluminium plate are better by hydrophobicity is poor due to too many hydroxyl groups contained therein such that the ink acceptability is poor and the chemical resistance for various processing agents is still insufficient. If the ink acceptability of the photosensitive layer is poor, problems such as the reduction of image density in prints and a fall in the durability for printing or difficulties in keeping the balance between water and ink for printing may arise.

The object of the present invention is therefore to offer a photosensitive condensation product for a lithographic printing plate in which such disadvantages and weak points of the conventional photosensitive products are mitigated or eliminated.

The photosensitive condensation product of the present invention possesses good preservability, food film forming performance and good adhesion to an aluminium support, and a lithographic printing plate made from said photosensitive condensation product has excellent developability resistance to processing agents, and ink acceptability of the developed printing plate compared with those made from a conventional photosensitive condensation product.

We have found a photosensitive condensation product of a sulfonylchloride of o-benzoquinonediazide or o-naphthoquinonediazide and a polyhydroxyphenyl resin shown in the following general formula:

General formula

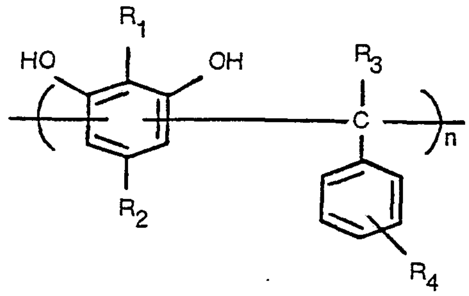

(In the formula, $R_1$ is a hydrogen atom or a hydroxyl group, $R_2$ is a hydrogen or halogen atom, or a lower alkyl or alkoxy group (number of carbon atoms: 1—4), $R_3$ is a hydrogen atom of a lower alkyl group (number of carbon atoms: 1—4), an aryl group or substituted aryl group, $R_4$ is a hydrogen or halogen atom, or an alkyl or alkoxy group (number of carbon atoms: 1—8) or a nitro group, and n is an integer of 3 or more.)

This resin can be synthesized by reacting a polyhydric phenol and an aldehyde or ketone.

Examples of the polyhydric phenol include, resorcinol, 5-chlororesorcinol, 5-methoxyresorcinol, 5-methylresorcinol, 5-ethylresorcinol, 5-t-butylresorcinol, pyrogallol, 5-chloropyrogallol, 5-methoxypyrogallol, 5-methylpyrogallol, 5-ethylpyrogallol or 5-t-butylpyrogallol; resorcinol and 5-methylresorcinol are particularly preferable.

Examples of the aldehyde or ketone are benzaldehyde, 4-methylbenzaldehyde, 4-ethylbenzaldehyde, 4-t-butylbenzaldehyde, acetophenone, 4-methylacetophenone, benzophenone, 4-methylbenzophenone and 4-4′-dimethylbenzophenone; benzaldehyde and 4-methylbenzaldehyde are particularly preferable.

The preferred resin of the general formula is a reaction product of resorcinol or 5-methylresorcinol and benzaldehyde or 4-methylbenzaldehyde, that is, in the general formula $R_1$ is hydrogen, $R_2$ is hydrogen or a methyl group, $R_3$ is hydrogen, $R_4$ is hydrogen or a methyl group.

The groups of these polyhydric phenols and aldehydes or ketones may be freely combined with each other and further, co-condensation is possible with mixtures of more than two. Further, co-condensation of a cresol group with formaldehyde as used so far, is also possible.

Polyhydroxyphenyl resins with the aforementioned general formula in the present invention can be made as follows: 1 mol of the aforesaid polyhydric phenol and 0.85—1.0 mol of the aforesaid aromatic aldehyde or ketone group by themselves, or in an alcoholic solution, are condensed with an acid catalyst such as hydrochloric acid or oxalic acid or an alkaline catalyst such as sodium hydroxide and aqueous ammonia. It is possible to obtain different molecular weights by changing the mol ratio of the monomers and the condensation reaction conditions. Preferably n is a number such that the resin has a molecular weight of about 600—10 000, more preferably about 800—4 000.

A typical example of the synthesis of 2 polyhydroxyphenyl resin for use in the present invention is given as follows.

Synthesis example 1

Resorcinol, 550 g is dissolved in 1 l of ethanol and 530 g of benzaldehyde is added thereto and, as a catalyst, 0.5 ml of 35% concentrated hydrochloric acid is added. The mixture is stirred and heated in an oil bath and after the start of boiling (reflux) of the reacting mixture caused by the heat of reaction, heating is reduced slightly and for another 90 minutes heating and reflux are continued. After the reaction is completed the reacted mixture is poured into 5 l of cold water with stirring; thereby a powder resin of light-brown colour is obtained. The yield thereof is 945 g. The molecular weight of this condensation product measured by osmotic pressure is about 1 400.

Synthesis example 2

In 1 l of dioxane, 621 g of 5-methylresorcinol is dissolved and 530 g of benzaldehyde is added thereto and as a catalyst 30 g of phosphorusoxychloride is added. After the mixture has been stirred for 24 hours at room temperature, it is poured, with stirring, into 5 l of cold water. Powdered resin of light-brown colour is obtained. The yield thereof is 986 g. The molecular weight of this condensation product measured by osmotic pressure is about 1 700.

Synthesis example 3

In 1 l of dioxane, 550 g is dissolved and then 600 g of acetophenone is added and 0.5 ml of 35% concentrated hydrochloric acid is added as a catalyst. The mixture is heated, with stirring, in an oil bath and after the temperature has reached 85°C with heat of reaction, heating is reduced slightly and heating and stirring are continued at about 80°C for 3 hours. After the reaction, the mixture is poured, with stirring, into 5 l of cold water whereby a powdered resin of light-brown colour is obtained. The yield thereof was 671 g. The molecular weight of this condensation product as measured by osmotic pressure is about 2 100.

Synthesis example 4

In 1 l of ethanol, 630 g of pyrogallol is dissolved and then 530 g of benzaldehyde is added and as a catalyst, 30 g of phosphorusoxy chloride is added. After the mixture has been stirred at room temperature for 24 hours, it is poured, with stirring, into 5 l of cold water. Powdered resin of reddish brown color is obtained. The yield thereof is 765 g. The molecular weight of this condensation product measured by osmotic pressure is about 1 600.

Other polyhydroxyphenyl resins can be synthesised in the same or similar manner.

Specific sufonylchlorides of o-benzoquinonediazide or o-naphthoquinonediazide which can be used in the present invention include 4-chlorosulfonyl-o-benzoquinonediazide, 4-chlorosulfonyl-o-naphthoquinonediazide or 5-chlorosulfonyl-o-naphthoquinonediazide, or a substituted derivative thereof.

The condensation product of the sulfonylchloride of o-benzoquinonediazide or of o-naphthoquinonediazide (which is referred as a "sulfonylchloride of diazide compound" hereinafter) and the polyhydroxyphenyl resin can by synthesised as follows: the sulfonylchloride of the diazide compound and the polyhydroxyphenyl resin are dissolved in a solvent such as dioxane or tetrahydrofuran and alkali such as sodium carbonate or potassium carbonate is added with stirring and heating at 40—50°C, which causes esterification. For all polyhydroxyphenyl resins prepared in the examples of the present specification, the yield is more than 90%. Regarding the reaction ratio of the sulfonylchloride of diazid compound to polyhydroxyphenyl resin, a molar ratio of typically 1:0.4—1:3 (when $R_1$ is a hydroxy group) or 1:0.4—1:2 (when $R_1$ is a hydrogen atom) can be used and preferably 1:0.5—1:2 ($R_1$ is a hydroxy group) or 1:0.5—1:1.5 ($R_1$ is a hydrogen atom); in other words a ratio of 1:0.5—1:3 is generally usable and the most suitable ratio is 1:0.7—1:2, by weight. Preferably these condensation products are used by themselves but, if circumstances require, it is possible to mix them with an alkali soluble novolak resin in various proportions; by changing this mixing ratio, it is possible to freely regulate the developability of the photosensitive layer by an aqueous alkaline solution. The resulting condensation product of the present invention is suitably dissolved in a solvent such as methylcellosolve (monomethyl ether of ethylene glycol), cellosolve, methylcellosolve acetate, dioxane and methylethylketone and coated onto an appropriate support such as an aluminium plate, zinc plate, copper plate, magnesium plate, plastic film and paper, among which the aluminium plate is most suitable. A range for the coating weight of the photosensitive layer of 0.1—4 g/m² proved to be satisfactory for a printing plate and the range of 1—3 g/m² is especially satisfactory. The abovementioned photosensitive composite can contain various additives which have been used in such layers.

As for the pre-sensitised plate onto which the condensation product of the present invention is coated, a relief image of positive-positive type can be obtained by contacting the original picture having a line drawing or half-tone dot image with the photosensitive surface for exposure and by developing with aqueous alkaline solution. Suitable light sources for the exposure are for example: carbon arc lamp, xenon lamp, mercury lamp, chemical lamp, photographic flash lamp and tungsten lamp and typical examples of aqueous alkaline solutions for the development are: aqueous solutions of sodium hydroxide, potassium hydroxide, calcium hydroxide, sodium carbonate, potassium carbonate, sodium metaborate, tertiary sodium phosphate, secondary sodium phosphate, sodium metasilicate and sodium formate.

A lithographic printing plate, of which the photosensitive layer contains the condensation product of the present invention has superior development performance to that of a diazoxide cresol-formaldehyde resin which has been used in practice; the alkaline density of the developer can be 1/2 to 1/3 that required for the diazoxide cresol-formaldehyde resin. Further, a large number of prints can be made with the printing plate thus obtained without any necessity of applying an additive such as a sensitive improver because it has superb ink receptivity and chemical resistance. These effects are in all likelihood due to the nature of polyhydroxy phenyl resin itself; thus it is likely that the superb ink receptivity is due to the existence of many alkyl groups in the side chains of alkyl derivatives of the polyhydroxy phenyl resin and that the superb development performance is due to the presence of many unreacted hydroxyl groups therein. The pre-sensitized plate used with the photosensitive composite of the present invention is a really useful one, as described above.

The following examples further illustrate the present invention.

Example 1

In 1 l of methylcellosolve, 100 g of the condensation product of 7 parts by weight of 1,2-naphthoquinone-2-diazide-5-sulfonyl-chloride and 10 parts by weight of resorcinolbenzaldehyde resin (product of synthesis example 1) and 1 g of dye (methylviolet made by Hodogaya Chemical Co Ltd CI 42535) are dissolved; thereby a photosensitive liquid is obtained and this photosensitive liquid is coated with a roller onto a grained aluminum plate to a thickness of 0.24 mm so that the weight after drying is 1.8 g/m².

On the surface of the photosensitive plate thus prepared, a positive transparent original picture is contacted and exposed for 40 seconds by a metalhalide lamp of 2 KW position at 70 cm distance. After the photosensitive plate is dipped in a 2% aqueous solution of sodium metasilicate, the exposed portion

is quickly dissolved and an offset printing plate having excellent receptivity and resistance to processing agent is obtained.

After this printing plate is set in an offset press and printing is made, it proved to possess excellent ink receptivity and a large number of prints with good image were obtained.

Comparative example 1

In 1 l of methylcellosolve, 100 g of condensation product of 7 parts by weight of 1,2-naphthoquinone-2-diazide-5-sulfonyl-chloride and 10 parts by weight of cresol-formaldehyde resin (phenolresin MP—707 made by Gun-ei Chemical Industry Co Ltd) and 0.7 g of dye (methylviolet made by Hodogaya Chemical Co Ltd Cl No 42535) are dissolved. The photosensitive liquid so obtained is coated onto a grained aluminium plate in the same manner as aforesaid so that the thickness of the coated layer after drying is 1.8 $g/m^2$.

The photosensitive plate thus prepared is exposed under the same conditions as aforesaid and then the development is attempted in the same manner in 2% solution of sodium metasilicate; this showed that it takes longer developing time and that ink adhered to the entire surface after applying ink for printing. By raising the concentration of the solution of sodium metasilicate, it is found that the concentration with which the development is made perfectly under the same conditions as the case of the aforesaid polyhydroxyphenyl series was 6%.

When the printing plate thus obtained is used on an offset printer, it is found that the ink receptivity is remarkably inferior and that the number of spoilt papers i.e. spoilage, until printed matter having enough ink density can be obtained from the first impression was approximately two times more than that when using alkyl derivatives of polyhydroxy phenyl and further that the printing durability thereof was approximately 2/3 of that of the said compared material.

The chemical resistance of the two kinds of the printing plates thus obtained are compared. First, the durability against isopropylalcohol which is used with the Dahlgren damping system is examined. When the two printing plates are soaked in 50% solution of isopropylalcohol for an hour at room temperature, the ratio of the image loss of the plate coated with cresol-formaldehyde photosensitizer is 62 weight per cent, while that of the plate coated with polyhydroxyphenyl photosensitizer is 16 weight per cent. When a photosensitizer binding quinonediazide group with a monomer (e.g. a combination of a orthonaphthoquinone diazide sulfonyl ester of cumyl phenol and a cresol-formaldehyde resin) is used as the photosensitive layer of the printing plate, and the resistance against isopropylalcohol of the said printing plate corresponds to 95 weight per cent image loss ratio under the same conditions.

There are a number of chemicals used for processing printing plates, and the order of chemical resistance to all of them follows closely that given above. For instance, the durability against developing ink (PS Plate Developing Ink PI—2, made by Fuji Photo Film Co Japan) is also in a similar order; after the above described three printing plates are soaked for 30 minutes at room temperature, the photosensitive plates of cumyl phenol ester and of cresol formaldehyde are both harmed by the ink component and the aluminium surfaces thereof are partially bared whereas, on the other hand, the photosensitive substance of polyhydroxyphenyl is not harmed by the ink component and the aluminium surface is not bared.

Comparative example 2

100 g of the condensed product of 8 parts by weight of 1,2-naphthoquinone-2-diazide-5-sulfonylchloride and 10 parts by weight of resorcinol-formaldehyde resin, and 1 g of dyestuff (methylviolet, by Hodogaya Chemical Industry Co Japan Cl No 42535) are dissolved in 1l of ethylcellosolve, by which a photosensitive liquid is prepared. Following the same method as example 1, the said photosensitive liquid is coated onto a sandblasted aluminium plate with a roller, so that the weight of the liquid after drying becomes 1.8 $g/m^2$. The thus prepared photosensitive plate is exposed under the same conditions as that of example 1 and is developed in 2% solution of sodium metasilicate in a manner similar to example 1.

Next, the photosensitive plates according to example 1 and from this example are compared for their ink receptivity and chemical resistance. When each of the said plates is used in an offset printer to print under conditions similar to that of the comparative example 1, the photosensitive substance of resorcinol-formaldehyde is found to be inferior in ink receptivity and the spoilage was approximately 2.5 times more until printed matter is obtained with sufficient ink density and further its printing durability is approximately 2/3, as compared with the photosensitive plate according to example 1.

The chemical resistance of the said two kinds of printing plates are compared under conditions similar to that of the comparison example 1. The ratio of image loss of the photosensitive substance of resorcinol-benzaldehyde after being soaked in 50% solution of isopropyl alcohol is 15 weight per cent, while that of the photosensitive substance of resorcinol-formaldehyde is 57 weight per cent.

Next, the said photosensitive substances are soaked in developing ink (PS Plate Developing Ink, PI—2, Registered Trade Mark of Fuji Photo Film Co Japan) and then the surfaces of the said two substances are compared; the photosensitive substance of resorcinol-formaldehyde is harmed by the ink components and its aluminium surface is bared, while, on the other hand, the photosensitive substance of resorcinol-benzaldehyde is not harmed by the ink components and its aluminium surface is not bared.

Comparative example 3

100 g of the condensed product of 7 parts by weight of 1,2-naphthoquinone-2-diazide-5-sulfonylchloride and 10 parts by weight of pyrogallol-acetone resin (of which the synthesis is similar to that of synthesis example 2; i.e. it is obtained by dissolving pyrogallol in acetone and by reacting with phosphorusoxy chloride as catalyst for 24 hours), and 1 g of dyestuff (Methylviolet, made by Hodogaya Chemical Industry Co Japan CI No 42535) are dissolved in 1l of methylcellusolve, by which a photosensitive liquid is prepared; the said photosensitive liquid is coated using a roller by a method similar to that of example 1, so that the coating is made at the rate of 1.8 $g/m^2$ of the liquid.

The thus prepared photosensitive plate is exposed to light under conditions similar to that of example 1 and then developed with a 2% solution of sodium metasilicate; quick development is possible similar to the case of example 1.

A comparison of the ink receptivity and chemical resistance is made between the photosensitive plate obtained in example 1 and the one obtained in this example. When each of the printing plates is used on an offset printer to print under conditions similar to that of comparative example 1, the photosensitive substance of pyrogallol-acetone is found to be inferior in ink receptivity and required a spoilage approximately 3.5 times more, and further its printing durability is approximately 3/5, as compared with the photosensitive plate obtained in example 1.

Next, the chemical resistances, of the two printing plates are compared under similar conditions to that of comparative example 1. The ratio of image loss of the photosensitive substance of resorcinol-benzaldehyde after being soaked in 50% solution of isopropyalcohol is 17 weight per cent, while that of the photosensitive substance of pyrogallol-acetone is 40 weight per cent.

The photosensitive substances are soaked in a developing ink (PS Plate Developing Ink PI—2 made by Fuji Photo Film Co Japan), and then the surfaces of the two substances are compared, one of which the photosensitive substance of pyrogallol-acetone, is harmed by the ink components and its aluminium surface is bared, while on the other hand, the photosensitive substance of resorcine-benzaldehyde is not harmed by the ink components and the aluminium surface is not bared.

Example 2

60 g of the condensed product of 13 parts by weight of 1,2-naphthoquinone-2-diazide-5-sulfonylchloride and 10 parts by weight of 5-methylresorcinolbenzaldehyde resin (Synthesis example 2), 60 g of cresol-formaldehyde resin (Phenol Resin MP—707, Registered Trade Mark of Gun-ei Chemical Industries Co Japan), and 0.7 g of dyestuff (Oil-Blue-2N, C I No 61555 are dissolved in 1l of methylcellosolve, by which a photosensitive liquid is prepared; the said liquid is coated by a roller onto a sand-blasted aluminium plate 0.30 mm thick so that a dry coating of 2.5 $g/m^2$ is obtained.

A positive transparent original is placed in contact with the surface of the thus prepared photosensitive plate and exposed by a 2 KW metal halide lamp from a distance of 70 cm for 50 seconds. Successively, the said photosensitive plate is soaked in 3% solution of sodium metasilicate, by which the exposed area is dissolved quickly; then an offset printing plate having superb oil-sensitivity and chemical resistance is obtained.

The chemical resistance of the said printing plate is tested under conditions similar to that of comparison example 1. The ratio of the image loss after being soaked in 50% solution of isopropylalcohol is 29 weight per cent.

When the surface of the photosensitive plate is checked after being soaked in developing ink (PS Plate Developing Ink PI—2, made by Fuji Photo Film Co Japan) the aluminium surface thereof is found not to be harmed by the ink components and also is not bared.

Example 3

100 g of the condensed product of 7 parts by weight of 1,2-naphthoquinone-2-diazide-5-sulfonylchloride and 10 parts by weight of resorcinol-4-methylbenzaldehyde resin, and 0.7 g of dyestuff (Aizen Victoria Pure Blue-BOH, Registered Trade Mark of Hodogaya Chemical Co Japan CI No 42595) are dissolved in 1l of ethylcellosolve, by which a photosensitive liquid is prepared; this is coated onto a sandblasted aluminium plate 0.24 mm thick by a roller so that the coating is made at the rate of 2.0 $g/m^2$ after drying.

The thus prepared photosensitive plate is exposed to light for 50 seconds by a method similar to that of example 1, and is then soaked in 3% solution of sodium metasilicate, by which the exposed area is quickly dissolved, and an offset printing plate having superb oil-sensitivity and chemical resistance is obtained.

When the printing plate thus obtained is used on an offset printer to print, the ink receptivity is superior; the spoilage required was approximately 1/2 and further the printing durability is approximately 2.3 times more, in comparison with the photosensitive substance of cresol-formaldehyde which as so far been used.

Next, the chemical resistance of the said printing plate is tested under similar conditions of those of comparative example 1 and the ratio of the image loss caused by 50% solution of isopropylalcohol is 17 weight per cent; the aluminium surface thereof is not harmed by soaking in developing ink (PS Plate Developing Ink PI—2, made by Fuji Photo Film Co Japan) and was not bared thereby.

Example 4

100 g of the condensed product of 7 parts by weight of 1,2-naphthoquinone-2-diazide-5-sulfonyl chloride and 10 parts by weight of resorcinol-acetophenone resin (Synthesis example 3), and 0.7 g of the dyestuff (Oil-blue, #603, made by Orient Chemical Industries Co Japan CI No 50400) are dissolved in 1l of ethylcellusolve, by which a photosensitive liquid is prepared; it is then coated onto a sand-blasted aluminium plate by a method similar to that of example 1.

The thus prepared photosensitive plate is exposed for 45 seconds by a method similar to that of example 1, and is then developed with 5% solution of tertiary sodium phosphate; an offset printing plate having superb oil-sensitivity and chemical resistance is obtained.

Example 5

30 g of the condensed product of 19 parts by weight of 1,2-naphthoquinone-2-diazide-5-sulfonylchloride and 10 parts by weight of pyrogallol-benzaldehyde resin (Synthesis example 4), 100 g of cresol-formaldehyde resin (Hitanol #3110, made by Hitachi Chemical Industries Co·Japan), and 0.85 g of dyestuff (Oil-Blue #603, made by Orient Chemical Industries Co Japan same as in example 4) are dissolved in 1l of methylcellosolve, by which a photosensitive liquid is prepared; it is then coated onto a sandblasted aluminium plate by a method similar to that of example 1.

The thus prepared photosensitive plate is exposed to light for 60 seconds by a method similar to that of example 1 and developed in 40% solution of sodium metasilicate; an offset printing plate having superb oil-sensitivity and chemical resistance is obtained.

It is pointed our that in our European Application No 0 021 716 we describe and claim a condensation product of a sulfonylchloride of o-benzoquinonediazide or o-naphthoquinonediazide and a polyhydric phenol resin possessing 3 or more units having the following general formula;

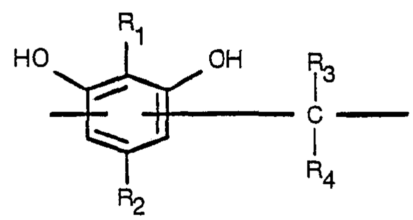

where $R_1$ is an alkyl group having 1 to 8 carbon atoms, $R_2$ is a hydrogen or halogen atom or an alkyl or alkoxy group having 1 to 4 carbon atoms, $R_3$ and $R_4$ are individually a hydrogen atom or an alkyl group having 1 to 4 carbon atoms or a phenyl group.

**Claims**

1. A condensation product of a sulfonylchloride of o-benzoquinonediazide or o-naphthoquinonediazide and a polyhydric phenol resin possessing 3 or more units having the following general formula:

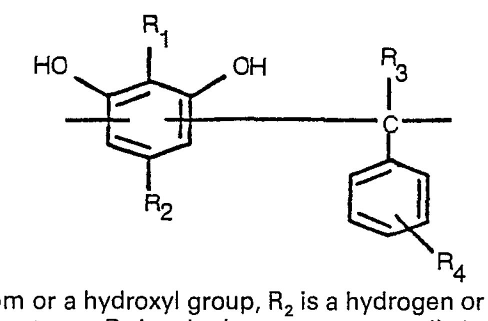

where $R_1$ is a hydrogen atom or a hydroxyl group, $R_2$ is a hydrogen or halogen atom or an alkyl or alkoxy group having 1 to 4 carbon atoms, $R_3$ is a hydrogen atom, an alkyl group having 1 to 4 carbon atoms, an aryl group or a substituted aryl group and $R_4$ is a hydrogen or halogen atom or an alkyl, or alkoxy group having at most 8 carbon atoms or a nitro group.

2. A condensation product according to claim 1 in which $R_1$ represents a hydrogen atom or a methyl group.

3. A condensation product according to claim 1 in which $R_3$ represents a hydrogen atom and $R_4$ represents a hydrogen atom or a methyl group.

4. A condensation product according to any one of claims 1 to 3 in which the molecular weight of the polyhydric phenol resin is 800 to 4000.

5. A condensation product according to any one of claims 1 to 4 in which the molar ratio of the sulfonylchloride of o-benzoquinonediazide or o-naphthoquinonediazide to the polyhydric phenol is 1:0.4 to 1:3 when $R_1$ is a hydroxy group or 1:0.4 to 1:2 is a hydrogen atom.

6. A condensation product according to any one of claims 1 to 5 of a sulfonylchloride of o-naphthoquinonediazide and a said polyhydric phenol resin in which $R_4$ is a hydrogen or halogen atom or an alkyl or alkoxy group having 1 to 8 carbon atoms or a nitro group.

7. A photosensitive composition comprising a photosensitive material and a carrier or diluent characterised in that the photosensitive material is a condensation product as claimed in any one of the preceding claims.

8. A photosensitive lithographic printing plate having a photosensitive layer coated on a support characterised in that the layer contains a condensation product as claimed in any one of claims 1 to 6.

**Patentansprüche**

1. Kondensationsprodukt eines Sulfonylchlorids von einem o-Benzochinondiazid oder von o-Naphthochinondiazid mit einem Polyhydroxyphenolharz, das 3 oder mehr Einheiten gemäß der nachfolgenden allgemeinen Formel aufweist:

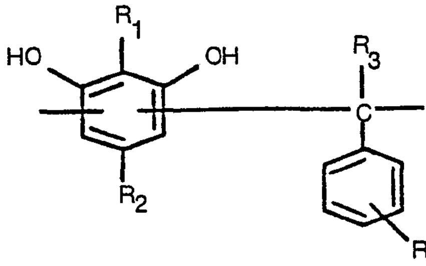

worin $R_1$ ein Wasserstoffatom oder eine Hydroxylgruppe $R_2$ ein Wasserstoff- oder Halogenatom oder eine Alkyl- oder Alkoxygruppe mit 1 bis 4 Kohlenstoffatomen, $R_3$ ein Wasserstoffatom, eine Alkylgruppe mit 1 bis 4 Kohlenstoffatomen, eine Arylgruppe oder eine substituierte Arylgruppe und $R_4$ ein Wasserstoff- oder Halogenatom oder ein Alkyl- oder Alkoxygruppe mit höchstens 8 Kohlenstoffatomen oder eine Nitrogruppe bedeutiet.

2. Kondensationsprodukt nach Anspruch 1, dadurch gekennzeichnet, daß $R_1$ für ein Wasserstoffatom und $R_2$ für ein Wasserstoffatom oder eine Methylgruppe steht.

3. Kondensationsprodukt nach Anspruch 1, dadurch gekennzeichnet daß $R_3$ für ein Wasserstoffatom und $R_4$ für en Wasserstoffatom oder eine Methylgruppe steht.

4. Kondensationsprodukt nach einem der vorhergehenden Ansprüche 1 bis 3, dadurch gekennzeichnet, daß das Molekulargewicht des Polyhydroxyphenolharzes 800—4000 beträgt.

5. Kondensationsprodukt nach einem der vorhergehenden Ansprüche 1 bis 4, dadurch gekennzeichnet, daß das Molverhältnis des Sulfonylchlorids von o-Benzochinondiazid oder o-Naphthochinondiazid zum Polyhydroxyphenol 1:0.4 bis 1:3 beträgt, wenn $R_1$ für eine Hydroxylgruppe steht oder 1:0.4 bis 1:2, falls $R_1$ ein Wasserstoffatom bedeutet.

6. Kondensationsprodukt nach einem der vorhergehenden Ansprüche 1 bis 5 eines Sulfonylchlorids von o-Naphthochinondiazid mit dem genannten Polyhydroxyphenolharz, dadurch gekennzeichnet, daß $R_4$ Wasserstoff- oder Halogenatom oder eine Alkyl- oder Alkoxygruppe mit 1 bis 8 Kohlenstoffatomen oder eine Nitrogruppe bedeutet.

7. Photoempfindliche Zusammensetzung aus einem photoempfindlichen Material und einem Träger oder Verdünnungsmittel, dadurch gekennzeichnet, daß das photoempfindliche Material ein Kondensationsprodukt gemäß einem der vorhergehenden Ansprüche ist.

8. Photoempfindliche lithographische Druckplatte mit einer als Überzug auf einem Träger aufgebrachten photoempfindlichen Schicht, dadurch gekennzeichnet, daß die Schicht ein Kondensationsharz nach einem der vorhergehenden Ansprüche 1 bis 6 enthält.

**Revendications**

1. Produit de condensation d'un chlorure de sulfonyle d'o-benzoquinonediazide ou d'o-naphthoquinonediazide et d'une résine phénol polyhydrique ayant 3 ou plusieurs unités correspondant à la formule générale suivante:

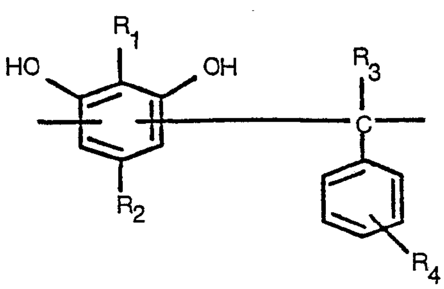

dans laquelle $R_1$ est un atome d'hydrogène ou un groupe hydroxyle, $R_2$ est un atome d'hydrogène ou d'halogène ou un groupe alkyle ou alkoxy ayant de 1 à 4 atomes de carbone, $R_3$ est un atome d'hydrogène, un groupe alkyle ayant de 1 à 4 atomes de carbone, un groupe aryle ou un groupe aryle substitué et $R_4$ est un atome d'hydrogène ou d'halogène ou un groupe alkyle or alkoxy ayant au plus 8 atomes de carbone ou un groupe nitro.

2. Produit de condensation selon la revendication 1 dans lequel $R_1$ représente un atome d'hydrogène et $R_2$ représente un atome d'hydrogène ou un groupe méthyle.

3. Produit de condensation selon la revendications 1, dans lequel $R_3$ représente un atome d'hydrogène et $R_4$ représente un atome d'hydrogène ou un groupe méthyle.

4. Produit de condensation selon l'une quelconque des revendications 1 à 3, dans lequel le poids moléculaire de la résine phénol polyhydrique est de 800 à 4.000.

5. Produit de condensation selon l'une quelconque des revendications 1 à 4, dans lequel le rapport molaire du chlorure de sulfonyle d'o-benzoquinonediazide ou d'o-naphthoquinonediazide ou phénol polyhydrique et de 1:0,4 à 1:3 lorsque $R_1$ est un groupe hydroxy our de 1:0,4 à 1:2 lorsque $R_1$ est un atome d'hydrogène.

6. Produit de condensation selon l'une quelconque des revendications 1 à 5, d'un chlorure de sulfonyle d'o-naphthoquinonediazide et d'une résine phénol polyhydrique dans laquelle $R_4$ est un atome d'hydrogène ou d'halogène ou un groupe alkyle ou alkoxy ayant de 1 à 8 atomes de carbone ou un groupe nitro.

7. Composition photosensible comprenant un matériau photosensible et un véhicule ou diluant, caractérisé par le fait que le matériau photosensible est un produit de condensation tel que revendiqué selon l'une quelconque des revendications précédentes.

8. Plaque d'impression lithographique photosensible ayant une couche photosensible appliquée sur un support, caractérisé par le fait que la couche contient un produit de condensation tel que revendiqué selon l'une quelconque des revendications 1 à 6.